(19) Europäisches Patentamt
European Patent Office
Office européen des brevets

(11) Publication number: **0 233 747 B1**

(12) **EUROPEAN PATENT SPECIFICATION**

(45) Date of publication of patent specification: **02.12.92**

(51) Int. Cl.5: **G03F 7/16**, G03F 7/26

(21) Application number: **87301125.8**

(22) Date of filing: **10.02.87**

Divisional application 90201328.3 filed on 10/02/87.

# (54) Vapor deposited photoresists of anionically polymerizable monomers.

(30) Priority: **10.02.86 US 828107**
**10.02.86 US 828109**

(43) Date of publication of application:
**26.08.87 Bulletin 87/35**

(45) Publication of the grant of the patent:
**02.12.92 Bulletin 92/49**

(84) Designated Contracting States:
**AT BE CH DE ES FR GB GR IT LI LU NL SE**

(56) References cited:
**EP-A- 0 049 884**
**EP-A- 0 136 421**
**WO-A-85/02030**
**US-A- 3 922 449**
**US-A- 4 081 276**
**US-A- 4 348 473**
**US-A- 4 551 418**

**INSTRUMENT AND EXPERIMENTAL TECHNIOUES, vol. 23, no. 6, part 11, November/December 1980, pages 1521-1523, Plenum Publishing Corp., New York, US; G.M. GUSAKOV et al.: "Apparatus for depositing organic films from the vapor state in response to UV light"**

(73) Proprietor: **LOCTITE (IRELAND) Ltd.**
**Whitestown Industrial Estate**
**Tallaght, Co. Dublin 24(IE)**

(72) Inventor: **Woods,John G.**
**138 Stillorgan Wood, Upper Kilmacud Road**
**Stillorgan, County Dublin(IE)**
Inventor: **Rooney,John M.**
**64 Water Street**
**South Glastonbury, Connecticut(US)**

(74) Representative: **Marchant, James Ian et al**
**Elkington and Fife Prospect House 8 Pembroke Road**
**Sevenoaks, Kent TN13 1XR(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

PATENT ABSTRACTS OF JAPAN, vol. 6, no. 259 (E-149)[1137], 17th December 1982 & JP-A-57 157 522 (NIPPON DENKI K.K.) 29-09-1982

IBM TECHNICAL DISCLOSURE BULLETIN, vol. 19, no. 7, December 1976, page 2688, New York, US; H. HIRAOKA: "Surface photopolymerization of methacrylic anhydride and dimethacrylimides"

IBM TECHNICAL DISCLOSURE BULLETIN, vol. 9, no. 11, April 1967, page 1473, New York, US; M.F. LEVY: "Preparing additive printed circuits"

PATENT ABSTRACTS OF JAPAN, vol. 8, no. 59 (E-232)[1496], 17th March 1984 & JP-A-58 209 123 (NIPPON DENSHIN DENWA KOSHA) 06-12-1983

## Description

The use of polymeric alkyl cyanoacrylates as resist materials for microlithography is known in the art. For example: IBM Technical Disclosure Bulletin, Vol. 16, No. 11, April 1974, p. 3745, discloses the use of poly methyl alpha cyanoacrylate homopolymers and copolymers as high-speed positive electron-beam resists; Japan Pat. No. 80/21,332 discloses the use of poly butyl cyanoacrylate as a positive-working high sensitivity electron-beam resist; Japan Pat. No. 80/105,244 discloses the use of poly ethyl cyanoacrylate as a positive-working electron-beam resist; U.S. Pat. No. 4,279,984 discloses the use of homopolymers and copolymers of lower alkyl cyanoacrylates as positive-working high energy radiation resists; Eur. Pat. No. 48,899 discloses the use of copolymers of alkyl cyanoacrylates as positive-working resists; Japan Pat. No. 82/87,404 discloses the use of polymeric fluoroalkyl cyanoacrylates as electron beam resists; Japan Pat. No. 83/113,933 discloses the use of copolymers of fluoroalkyl acrylates and alkyl cyanoacrylates as resist materials; Japan Pat. No. 83/108,213 discloses the use of alkyl cyanoacrylate polymers as positive-working radiation resist; and Japan Pat. No. 83/123,727 discloses the use of alkyl cyanoacrylate polymers and azido crosslinking agents as negative-working radiation resists.

In the prior art, the method of applying the resist materials to the substrate is by spin-coating a solution of cyanoacrylate polymer onto the substrate. This procedure requires that the polymer is prepared in advance of the application and then dissolved in a suitable solvent. The solution must be filtered to remove particles of dust before application. After application, the coated substrate must be baked to remove residual solvent. Preparation of cyanoacrylate polymers in large quantities is complicated by high reactivity of the monomers and the strongly exothermic nature of the polymerization.

After polymerization, the polymeric cyanoacrylate must then be precipitated to remove impurities such as initiators and inhibitors, a procedure which consumes large amounts of solvent. The purified polymer must then be redissolved in a suitable solvent for spin-coating. This requirement places a limitation on the types of solvent and polymer molecular weights which may be used. For example, poly methyl cyanoacrylate is soluble in very few solvents, such as nitromethane and dimethylformamide. In general, it is very difficult to spin-coat films of cyanoacrylate polymers with molecular weights in excess of 1,000,000 as stated in U.S. Pat 4,279,984, Col. 2, lines 23-28. However, films formed from polymers below this molecular weight are easily removed by common organic solvents necessitating shortened developing times as stated in U.S. Pat 4,279,984, Col. 3, lines 60-68, and Col. 4, lines 1 - 9. A further disadvantage of the spin-coating process is that attempts to coat a patterned substrate resulting in uneven coating thicknesses i.e., the coating is thicker in depressed regions than in raised regions. One method of overcoming this problem involves the use of multilayer resists. However, applying two or three layers and using two or three image development steps increases the cost and complexity of the lithographic process.

In the prior art, the method of imaging the cyanoacrylate-based resists involved spin-coating a solution of cyanoacrylate polymer onto the substrate and exposing the coated surface to high-energy radiation through a mask or to steered high-energy beams. In the case of positively imaged resists, the exposed portions of the coating are then removed by treatment with solvent, and in the case of a negatively imaged resist the unexposed portions are removed by solvent. This solvent development step inevitably results in some degree of distortion of that portion of the coating which is to remain on the substrate and form a relief image.

Methods are also known for forming images on a substrate by directly polymerizaing monomers imagewise onto areas of the substrate previously exposed to radiation.

European Patent Application No. 0136421-Hiraoka discloses a microlithographic process characterised by confining a monomer vapor in a closed chamber containing a substrate and exposing the monomer vapor to a patterned beam of ions to cause a patterned-exposed polymer film to be deposited on the surface of the substrate. Those areas of the substrate surface wherein the patterned-exposed polymerization did not occur may subsequently be etched using an oxygen plasma so as to form an etched image on the substrate surface.

U.S. 4,551,418 - Hult, et al., discloses a method for creating negative relief images on a substrate by a process comprising coating a substrate with an etchable substrate and a photoinitiator. Subsequently, exposing the photoinitiator treated surface (image-wise) to actinic radiation so as to activate the cationic polymerization catalyst in the exposed areas and thereafter exposing said substrate to a polymer vapor of a cationically polymerizable monomer so as to affect polymerization thereof in the activated areas. The polymer so formed is resistant to plasma etching such that the substrate may then be placed in a plasma environment and the unexposed areas of the film may be etched by plasma treatment to produce a high resolution negative tone relief image.

U.S. 4,081,276 - Crivello discloses a method of

forming an image on the surface of a substrate by treating the substrate with a photoinitiator, exposing the treated surface to radiant energy (optionally in an image-wise fashion) so as to cause the formation of a cationic polymerization catalyst on the exposed substrate surface. The substrate may then be contacted with a cationically polymerizable organic material resulting in the formation of an adherent organic film on the exposed substrate surface. This method may also be employed to create a negative photoresist by applying a mask on the treated substrate prior to exposing the photoinitiator to ultraviolet light.

International Application No. WO 85/020-Brault, et al. discloses a method for preparing graft polymerized $SiO_2$ lithographic masks. The method comprises applying a resist coating (either positive or negative resist) to a substrate via conventional methods, i.e., spin coating, and therafter irradiating the treated surface in order to generate organic free radicals. The reactive resist polymers subsequently exposed to an oxygen gas containing atmosphere in order to convert at least a substantial portion of the free radicals to a class of peroxides or hydroperoxides. These peroxides or hydroperoxides are later thermally decomposed to produce organic free radicals which are capable of reacting with an organic monomer, preferably a silicon-containing organic monomer to graft polymerize the same thereon.

Cyanoacrylate monomer vapors have recently been utilized as a fingerprint developer. A detailed discussion of such techniques is included in U.S. No. 4,550,041.

A method for applying a polymeric resist coating of a very high molecular weight to a suitable substrate without the necessity of elaborate purification steps and for ensuring adequate coverage of raised regions in three dimensionally patterned substrates forms the subject matter of a divisional Application No. 90201328.3 divided herefrom.

The present invention provides a method by which a vapour deposited polymeric coating of very high molecular weight is deposited imagewise to a suitable substrate so that subsequent solvent development is unnecessary.

This method consists of treating the substrate with a compound which releases acid when exposed to high-energy radiation. In certain cases when the surface of the substrate is slightly acidic or neutral, it is then necessary to activate the surface with a basic liquid or vapor which must be chosen so as not to react with the radiation-sensitive acid precursor. The substrate is exposed to actinic or ionizing radiation through a mask or to steered high-energy beams. Finally the substrate is exposed to a vapor of cyanoacrylate monomer which condenses and polymerizes on the unirradiated regions forming a relief image.

The present invention provides a method of providing an image on a substrate comprising (a) pretreating the substrate with a photo sensitive compound which releases an acid when exposed to actinic or ionizing radiation, (b) image-wise exposing the pretreated substrate to irradiation of an energy effective to release said acid from said photo sensitive, compound, (c) thereafter exposing the substrate to the vapor of an anionically polymerizable monomer of the formula:

$$CHR=CXY$$

where X and Y are strong electron withdrawing groups and R is H or, provided X and Y are both cyano groups, $C_1$-$C_4$ alkyl, for sufficient time to deposit a polymerized coating of the monomer on the surface of the substrate in the areas thereof not exposed to the irradiation; said substrate surface being active for inducing anionic polymerization of the monomer.

Among the advantages of this method are the following features:

1. Current C.A. resists require deep UV or high energy radiation to form an image. This invention allows mid UV or even visible light to be used (depending on absorption of latent acid material). In the inventive process, radiation response can be adjusted by changing the nature of the acid precursor. For example, long wavelength UV response can be obtained by the use of pyrylium salts; mid-UV response can be obtained by the use of diazonium or sulfonium salts; and deep UV response can be obtained by the use of iodonium salt photoinitiators.

2. As polymer is not formed in imaged sites, development does not require use of aggressive solvents.

3. Current positively images photoresist materials are formed by a polymer degradation mechanism which requires relatively high doses of radiation. By comparison, the present development relies on preventing polymerization in the imaged areas and only low doses of radiation are necessary to ensure acid formation.

The inventive process can be utilized to produce uniform etch resistant coatings of less than 0.1 micron thick.

The preferred monomers for use in the inventive process are cyanoacrylate esters, vinylidene cyanide and dialkyl methylene malonates. The well known cyanoacrylate monomers are especially preferred and many are commercially available as "instant" adhesives. The cyanoacrylate monomers have the formula:

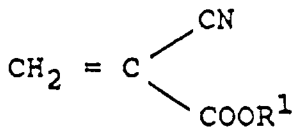

wherein $R^1$ represents a hydrocarbyl or substituted hydrocarbyl group such as a straight chain or branched chain alkyl group having 1 to 12 carbon atoms (which may be substituted with a substituent such as a halogen atom or an alkoxy group) a straight chain or branched chain alkenyl group having 2 to 12 carbon atoms, a straight chain or branched chain alkynyl group having 2 to 12 carbon atoms, a cycloalkyl group, an aralkyl group or an aryl group. Specific examples of the groups for $R^1$ are a methyl group, an ethyl group, an n-propyl group, an isopropyl group, an n-butyl group, an isobutyl group, a pentyl group, a hexyl group, an allyl group, a methallyl group, a crotyl group, a propargyl group, a cyclohexyl group, a benzyl group, a phenyl group, a cresyl group, a 2-chloroethyl group, a 3-chloropropyl group, a 2-chlorobutyl group, a trifluoroethyl group, a 2-methoxyethyl group, a 3-methoxybutyl group and a 2-ethoxyethyl group.

Preferred cyanoacrylate are alkyl cyanoacrylates having 1-6 carbon atoms. Ethyl and isobutyl cyanoacrylates are especially preferred.

The monomer vapors are most suitably generated from the monomers. This may be done at ambient temperatures and pressures but it is generally preferred to heat the monomers and/or reduce the atmospheric pressure above the monomer generated chamber in order to generate sufficient concentrations of vapor to accomplish the polymer deposition on the substrate in a reasonable time.

As an alternative to vapor generation from monomers, cyanoacrylate polymers which are heated above their depolymerization temperatures, typically about 150 ° C, may be used as a monomer vapor source. In particular, vapors generated from thermal removal of resist coatings may be recirculated, a feature which has significant environmental advantages.

Concentrated cyanoacrylate monomer vapors may also be generated by other techniques well known in the fingerprint development art and summarized in U.S. 4,550,041.

While the cyanoacrylate ester monomers are preferred because of their ready availability, better known handling properties and low depolymerization temperatures, other anionically polymerizable monomers encompassed within Formula I above may also be usefully employed. As used herein, the term "strong electron withdrawing groups" refers to groups which are more electron withdrawing than halo. Generally, the electron withdrawing groups X and Y may be independently selected from $-SO_2R$; $SO_3R$; -CN; $-COOR^1$ and $-COR^2$, where $R^1$ is as previously defined and $R^2$ is H or hydrocarbyl, preferably $C_1$-$C_{12}$ hydrocarbyl. Vinylidene cyanide, in particular, is known to give especially insoluble polymeric products. Vinylidene cyanide and its lower alkyl homologs may be obtained, for instance, by processes described in U.S. 2,313,501; 2,502,412; 2,514,387; 2,663,725, and 2,665,298, the disclosures of which are incorporated herein by reference. Other anionically polymerizable mononers within the scope of Formula I include: dialkyl methylene malonates as described in U.S. 2,330,033; 3,197,318; 3,221,745 and 3,523,097; acylacrylonitriles as described in GB 1,168,000; and vinyl sulfinates and sulfonates of the formula $CH_2=CXY$ where X is $-SO_2R^2$ or $-SO_3R^2$ and Y is -CN, $-COOR^2$, $-COCH_3$, $-SO_2R^2$ or $-SO_3R^2$, as described in U.S. 2,748,050.

Virtually, any substrate upon which a polymeric image is desired may be utilized in the inventive process. Most advantageously, the substrates will be ones which undergo subsequent acid or plasma etching during which the polymer coating serves as an etch resist. Suitable substrate materials include silicon dioxide, including $SiO_2$ coated silicon, metallic oxides, and glass, all of which may be etched by plasma or acid etching processes. Metallic substrates which can be etched by acid processes, such as copper coated epoxy/glass boards used in printed circuit board manufacture and metal printing plates may also be utilized in the inventive process. Where the inventive process is used to produce an etch resist, the resist coating may be removed after etching by heating the substrate above the depolymerization temperature of the polymer, preferably under vacuum.

The preferred substrate is $SiO_2$ coated silicon, e.g., the silicon chips conventionally used in preparation of semiconductor devices. Most suitably, this substrate is etched by a plasma etching process. Surprisingly, the high molecular weight cyanoacrylate polymers produced by the inventive process have a significantly greater etch resistance than spin coated cyanoacrylate polymer resists.

Very high molecular weight polymer is formed by the inventive process. This is evidenced by the inability of aggressive solvents such as dichloromethane to dissolve the coating. As noted above, however, the coating is readily removed by heating above the depolymerization temperature of the polymer. For cyanoacrylate polymers, the depolymerization temperature is only about 150-200 ° C so the coating removal step will not harm the typical substrate.

If the substrate surface is inherently active for inducing anionic polymerization of cyanoacrylates,

or such other monomer within Formula I as may be employed, no surface treatment will be necessary to obtain the desired high molecular weight uniform coatings. In certain cases, however, where the substrate is slightly acidic or neutral, it is necessary to activate the surface with a basic liquid or vapor which is substantially removed before exposing the substrate to the monomer vapor. Suitable activators include the known initiators for anionic or zwitterionic polymerization of alkyl cyanoacrylates. Especially suitable activators are organic amines and phosphines.

Where the coating is deposited directly as an image, it is necessary to pretreat the surface with a compound which releases an acid on irradiation. Compounds which release acid upon irradiation include any compounds which release Lewis or protonic acids such as those known as photoinitiators for cationically polymerizable resins such as epoxies or vinyl ethers. Additionally included are compounds which release sulfonic acids upon irradiation and are known as photolytically releasable latent thermal catalysts for acid curable stoving lacquers. The compounds, of course, should not produce an irradiation by-product which initiates cyanoacrylate polymerization. Thus, amine salts are not recommended.

Suitable radiation sensitive acid precursors useful in the inventive method include salts of complex halogenides represented by the formula:

$[A]_d^+ [MXe]^{-(e-f)}$

wherein A is a cation selected from iodonium iodosyl, Group VIa onium, pyrylium, thiopyrylium, sulfonylsulfoxonium, and diazonium, M is a metal or metalloid, X is a halogen radical, d = e - f, f = the valence of M and is an integer equal to from 2 to 7 inclusive and e is >f and is an integer having a value up to 8; compounds of the formula:

$R[O.SO_2.CQ_3]n$

wherein R is an organic radical of valency 1 to 4 and Q is hydrogen or fluorine and n is an integer from 1 to 4; and compounds which release sulfonic acids when irradiated such as those disclosed in U.S. Pats. 4,504,372 and 4,510,290, both incorporated herein by reference.

The acid generating compound may be applied neat or in a solvent which is subsequently evaporated. If a surface activator is also being applied to the substrate, both the activator and the acid generating compound may be applied simultaneously in a common solvent. Alternatively, the activator may be applied before or after application of the acid generating compound.

Only trace amounts of surface activator and acid generating compound are necessary. Mirror finish substrates may be repolished, e.g., with a suitable tissue, after application of these compounds and still retain sufficient activator and acid generator to give sharply imaged resists after irradiation and exposure to monomer vapor.

The invention is further illustrated by the following non-limiting examples.

Examples 1-10 illustrate the direct deposit imaging method of the invention.

Example 1:

A polished silicon wafer 3 inches in diameter was treated with three drops of UVE 1014 (trademark of General Electric), a commercially available salt of a complex halogenide, which were brushed uniformly across the surface of the wafer. The wafer was then polished with a paper tissue to restore the mirror finish. Three drops of N,N,N',N'-Tetramethyl Ethylene Diamine (TMEDA) were brushed uniformly across the surface of the wafer, which was then polished with a paper tissue again to restore the mirror finish. One half of the wafer surface was covered with a metal plate and the wafer was exposed to the output of a medium-pressure mercury arc (200 watts per linear inch power rating) at a distance of 10 centimeters for 10 seconds. At the end of this time, the metal plate was removed and the wafer was mounted perpendicular to the shaft of a stirring motor with a variable speed adjustment. The wafer was rotated at a speed of about 35 revolutions per minute and lowered into a 1 liter polyethylene beaker containing 0.5 grams of ethyl cyanoacrylate monomer. The wafer was lowered to a depth about 10 cm above the bottom of the beaker, which was heated to a temperature of 60 ° C on a hot plate apparatus. After two minutes exposure, the wafer was removed from the vapor. The half of the wafer which had not been exposed to the ultraviolet radiation was covered by a uniform film of cyanoacrylate polymer. The other half of the wafer remained uncoated.

Example 2:

The experiment described in Example 1 was repeated with the exception that in place of the UVE 1014 the wafer was treated with 10 drops of a 50 weight percent solution of benzoin dodecylbenzene sulfonate in propylene carbonate; the wafer was exposed to the ultraviolet radiation source for 30 seconds; and the water was exposed to the ethyl cyanoacrylate vapor for 6 minutes. At the end of that time, the half of the wafer which had not been exposed to the ultraviolet radiation was covered by a uniform film of cyanoacrylate polymer.

The other half of the wafer remained uncoated.

Example 3:

The experiment described in Example 1 was repeated with the exception that in place of the metal plate the water was covered with a patterned mask. After exposure to the cyanoacrylate vapor, a relief image corresponding to the pattern on the mask had been developed on the wafer surface.

Example 4:

The experiment described in Example 1 was repeated with the exception that in place of the UVE 1014 the wafer was treated with 3 drops of a 15 weight percent solution of 2,6-bis(4-methoxyphenyl)-4-phenyl pyrylium hexafluoroantimonate in propylene carbonate; the wafer was exposed to the ultraviolet radiation source for 60 seconds; and the wafer was exposed to the ethyl cyanoacrylate vapor for 2 minutes. At the end of that time, the half of the wafer which had not been exposed to the ultraviolet radiation was covered by a uniform film of cyanoacrylate polymer. The other half of the wafer remained uncoated.

Example 5:

The experiment described in Example 1 was repeated with the exception that in place of the UVE 1014 the wafer was treated with 5 drops of PP-33 (trademark of Asahi Denka), a commercially available diazonium salt photoinitiator solution; the wafer was exposed to the ultraviolet radiation source for 30 seconds; and the wafer was exposed to the cyanoacrylate vapor for 2 minutes. At the end of that time, the half of the wafer which had not been exposed to the radiation was covered by a film of cyanoacrylate polymer. The other half of the wafer remained uncoated.

Example 6:

The experiment described in Example 1 was repeated with the exception that in place of the UVE 1014 the wafer was treated with 5 drops of a 25 weight percent solution of di(p-tolyl)iodonium hexafluorophosphate in propylene carbonate; the wafer was exposed to the ultraviolet radiation through a photographic negative, part of which was covered by a 10mm thick glass plate, for 60 seconds; and the wafer was exposed to the cyanoacrylate vapor for 2 minutes. At the end of that time, a relief image corresponding to the pattern of the photographic negative had been developed on that part of the wafer not covered by the glass plate. The part of the wafer covered by the glass plate was covered by a uniform film of cyanoacrylate polymer approximately 0.2 microns in depth.

Example 7:

The experiment described in Example 1 was repeated with the exception that in place of the UVE 1014 the wafer was treated with 5 drops of a solution of 103 milligrams of di(p-tolyl)iodonium hexafluorophosphate and 81 milligrams of 2,2-dimethoxy-2-phenylacetophenone dissolved in 303 milligrams of propylene carbonate; the wafer was exposed to the ultraviolet radiation through a photographic negative which was entirely covered by a 10mm thick glass plate for 60 seconds; and the wafer was exposed to the cyanoacrylate vapor for 5 minutes. At the end of that time, a relief image corresponding to the pattern of the photographic negative had been developed on the wafer.

Example 8:

The experiment described in Example 1 was repeated with the exception that in place of the UVE 1014 the wafer was treated with 5 drops of a 16 weight percent solution of 2-methylsulfonyloxy benzophenone in propylene carbonate; the wafer was exposed to the ultraviolet radiation for 60 seconds; and the wafer was exposed to the cyanoacrylate vapor for 2 minutes. At the end of that time, the half of the wafer which had been shielded from the ultraviolet radiation was covered by a film of cyanoacrylate polymer. The other half of the wafer remained uncoated.

Example 9:

A glass microscope slide (1" x 4") was treated with 2 drops of UVE-1014, which were brushed uniformly across the surface of the slide. The slide was then polished with a paper tissue, and exposed through a patterned mask to the output of a medium-pressure mercury arc (200 watts per linear inch power rating) at a distance of 10 centimeters for 20 seconds. At the end of this time, the mask was removed and the slide was mounted perpendicular to the shaft of a stirring motor with a variable speed adjustment. The slide was rotated at a speed of about 35 revolutions per minute and lowered into a 1 litre polyethylene beaker containing 0.5 grams of ethyl cyanoacrylate monomer. The slide was lowered to a depth about 10 cm above the bottom of the beaker, which was heated to a temperature of about 50C on a hot plate apparatus. After 3 minutes exposure, the slide was removed from the vapor. A relief image corresponding to the pattern of the mask had been

developed on the surface of the slide.

Example 10:

The experiment described in Example 1 was repeated with the exception that in place of the UVE-1014 the wafer was treated with 3 drops of a 33 weight percent solution of ($\eta^6$ - cumene) ($\eta^5$ - cyclopentadienyl) - iron (II)-hexafluorophosphate in propylene carbonate; the wafer was exposed to the ultraviolet radiation for 180 seconds; and the wafer was exposed to the cyanoacrylate vapor for 3 minutes. At the end of that time, the half of the wafer which had been shielded from the ultraviolet radiation was covered by a film of cyanoacrylate polymer. The other half of the wafer remained uncoated.

**Claims**

**1.** A method of providing an image on a substrate comprising (a) pretreating the substrate with a photo sensitive compound which releases an acid when exposed to actinic or ionizing radiation, (b) image-wise exposing the pretreated substrate to irradiation of an energy effective to release said acid from said photo sensitive compound, (c) thereafter exposing the substrate to the vapor of an anionically polymerizable monomer of the formula:

$$CHR{=\!=\!=}CXY$$

where X and Y are strong electron withdrawing groups and R is H or, provided X and Y are both cyano groups, $C_1$-$C_4$ alkyl, for sufficient time to deposit a polymerized coating of the monomer on the surface of the substrate in the areas thereof not exposed to the irradiation; said substrate surface being active for inducing anionic polymerization of the monomer.

**2.** A method as in claim 1 wherein said substrate is an acid or plasma etchable substrate.

**3.** A method as in claim 1 where the monomer is selected from 2-cyano-acrylate esters, vinylidene cyanide and its $C_1$-$C_4$ alkyl homologs, dialkyl methylene malonate, acylacrylonitriles, and vinyl sulfinates or sulfonates of the formula $CH_2 = CXY$ where X is $-SO_2R^2$ or $SO_3R^2$ and Y is selected from -CN, $-COOR^2$, $-COCH_3$, $-SO_2R^2$ or $-SO_3R^2$ and $R^2$ is H or hydrocarbyl.

**4.** A method as in claim 3 where the monomer is cyanoacrylate ester.

**5.** A method as in claim 1 wherein the substrate is $SiO_2$ coated silicon.

**6.** A method as in claim 1 wherein the substrate surface has been activated to induce polymerization or the monomer by treatment with an initiator for anionic or zwitterionic polymerization of alkyl cyano-acrylates.

**7.** A method as in claim 6 wherein the initiator is an organic amine or phosphine.

**8.** A method as in claim 2 further comprising subsequently etching the imaged substrate and then removing the resist coating by heating the coating to a temperature above the polymer depolymerization temperature.

**9.** A method as in claim 1 wherein the polymerized coating is less than 0.1 $\mu$m thick.

**Patentansprüche**

**1.** Verfahren zur Bereitstellung eines Bildes auf einer Substratfläche, das (a) Vorbehandeln der Substratfläche mit einer lichtempfindlichen Verbindung, die bei Bestrahlung mit einer aktinischen oder ionisierenden Strahlung Säure freigibt, (b) bildweises Bestrahlen der vorbehandelten Substratfläche mit einer Energie, die zur Freisetzung der Säure aus der lichtempfindlichen Verbindung wirksam ist, (c) danach die Substratfläche dem Dampf eines anionisch polymerisierbaren Monomers der Formel:

$$CHR{=\!=\!=}CXY$$

worin X und Y stark elektronenziehende Gruppen sind und R gleich H unter der Voraussetzung ist, daß X und Y beides Cyanogruppen, $C_1$ - $C_4$ Alkylgruppen sind, für einen Zeitraum aussetzen, der ausreicht, um eine polymerisierte Beschichtung aus dem Monomer auf der Substratoberfläche in den Bereichen abzuscheiden, die nicht der Strahlung ausgesetzt sind, wobei die Substratoberfläche für die Einleitung der Polymerisation des Monomers aktiviert wird, umfäßt.

**2.** Verfahren wie in Anspruch 1, worin die Substratoberfläche eine säure- oder plasmaätzbare Substratoberfläche ist.

**3.** Verfahren wie in Anspruch 1, wo das Monomer aus 2-Cyanoacrylestern, Vinylidencyanid und aus seinen $C_1$ - $C_4$ Alkylhomologen, Dialkylmethylenmalonat, Acylacrylnitrilen und aus Vinylsulfinaten oder Sulfonaten der Formel $CH_2 = CXY$, wo X $-SO_2R^2$ oder $-SO_3R^2$ ist und Y aus -CN, $-COOR^2$, $-COCH_3$, $-SO_2R^2$ oder $-SO_3R^2$ ausgewählt wird und $R^2$ H oder eine Hydrocarbylgruppe ist, ausgewählt wird.

**4.** Verfahren wie in Anspruch 3, wo das Monomer ein Cyanacrylatester ist.

**5.** Verfahren wie in Anspruch 1, worin die Substratfläche ein mit $SiO_2$ beschichtetes Silikon ist.

**6.** Verfahren wie in Anspruch 1, worin die Substratoberfläche zur Polymerisationseinleitung oder das Monomer durch Behandlung mit einem Initiator zur anionischen oder zwitterionischen Polymerisation von Alkylcyanoacrylaten aktiviert worden sind.

**7.** Verfahren wie in Anspruch 6, worin der Initiator ein organisches Amin oder Phosphin ist.

**8.** Verfahren wie in Anspruch 2, das weiterhin nachfolgend Anätzen der mit Bildern versehenen Substratfläche und anschließend Entfernen der verbliebenen Beschichtung durch Erhitzen der Beschichtung auf eine Temperatur über die Polymer-Depolymerisationstemperatur umfaßt.

**9.** Verfahren wie in Anspruch 1, worin die polymerisierte Beschichtung weniger als 0,1 $\mu$m dick ist.

## Revendications

**1.** Un procédé pour former une image sur un substrat, consistant à (a) traiter préalablement un substrat avec un composé photosensible qui libère un acide lorsqu'il est exposé à un rayonnement actinique ou ionisant, (b) exposer selon une image le substrat préalablement traité à une énergie d'irradiation efficace pour libérer ledit acide dudit composé photosensible, puis (c) exposer le substrat à la vapeur d'un monomère anioniquement polymérisable de la formule :

$$CHR{=\!=}CXY$$

où X et Y sont des groupes électro-attractifs forts et R est H ou, si X et Y sont tous deux des groupes cyano, un groupe alkyle en $C_1$-$C_4$, pendant un temps suffisant pour déposer un revêtement polymérisé du monomère sur la surface du substrat dans les zones non irradiées de celui-ci ; ladite surface du substrat étant active pour provoquer la polymérisation anionique du monomère.

**2.** Un procédé selon la revendication 1, dans lequel ledit substrat est un substrat pouvant être gravé par un acide ou un plasma.

**3.** Un procédé selon la revendication 1, dans lequel le monomère est choisi parmi les esters 2-cyano-acryliques, le cyanure de vinylidène et ses homologues à groupement alkyle en $C_1$-$C_4$, un méthylène-malonate de dialkyle, les acylacrylonitriles et les vinylsulfinates ou vinylsulfonates de la formule $CH_2 = CXY$ où X est $-SO_2R^2$ ou $SO_3R^2$ et Y est choisi parmi -CN, $-COOR^2$, $-COCH_3$, $-SO_2R^2$ ou $-SO_3R^2$ et $R^2$ est H ou un groupe hydrocarbyle.

**4.** Un procédé selon la revendication 3, dans lequel le monomère est un ester cyano-acrylique.

**5.** Un procédé selon la revendication 1, dans lequel le substrat est du silicium revêtu de $SiO_2$.

**6.** Un procédé selon la revendication 1, dans lequel la surface du substrat a été activée pour provoquer la polymérisation du monomère par traitement avec un initiateur de polymérisation anionique ou zwitterionique de cyano-acrylates d'alkyle.

**7.** Un procédé selon la revendication 6, dans lequel l'initiateur est une amine ou phosphine organique.

**8.** Un procédé selon la revendication 2, consistant de plus à graver ensuite le substrat portant une image, puis à enlever le revêtement de réserve par chauffage du revêtement à une température supérieure à la température de dépolymérisation du polymère.

**9.** Un procédé selon la revendication 1, dans lequel le revêtement polymérisé a une épaisseur inférieure à 0,1 $\mu$m.